# EUROPÄISCHE PATENTSCHRIFT

(11) **EP 2 780 956 B1**
(45) Veröffentlichungstag und Bekanntmachung des Hinweises auf die Patenterteilung: **14.04.2021**
(21) Anmeldenummer: 12788188.6
(22) Anmeldetag: 15.11.2012
(51) Int. Cl.: H01L 33/64, H01L 33/50

(54) **LED-MODUL**
LED MODULE
MODULE LED

(30) Priorität: 15.11.2011 DE 102011086359
(43) Veröffentlichungstag der Anmeldung: 24.09.2014
(73) Patentinhaber: Tridonic GmbH & Co. KG, 6851 Dornbirn (AT)
(72) Erfinder: MUEHLBACHER, Gerd, A-6845 Hohenems (AT); KERBER, Stefan, A-6900 Bregenz (AT); BRYDON, Gavin, Gateshead Tyne and Wear NE11 9QH (GB)
(74) Vertreter: Rupp, Christian
(86) Internationale Anmeldenummer: PCT/EP2012/072704
(87) Internationale Veröffentlichungsnummer: WO 2013/072407

(56) Entgegenhaltungen:
- EP-A2- 1 487 025
- WO-A1-2006/006544
- US-A1- 2004 211 970
- US-A1- 2005 139 846
- US-A1- 2010 295 070
- US-A1- 2011 198 628

## Beschreibung

Die vorliegende Erfindung bezieht sich auf eine Leuchtdioden-Anordnung gemäß dem Oberbegriff des Anspruchs 1, welche einen Leuchtdioden-Chip ("LED Die") aufweist, der von einem Farbkonversions-Material umgeben ist, das dazu benutzt wird, zumindest einen Teil des von dem Leuchtdioden-Chip abgegebenen Lichts in Licht einer anderen Wellenlänge umzusetzen.

Den Hintergrund der vorliegenden Erfindung bildet das Gebiet der Leuchtdioden und insbesondere das Gebiet der sogenannten weißen Leuchtdioden oder LEDs. Aus dem Stand der Technik ist es bekannt, das Licht z.B. blauer LEDs mittels Farbkonversion in weißes Mischlicht umzusetzen, in dem ein Phosphor das von dem Leuchtdioden-Chip ausgestrahlte Licht absorbiert und in ein langwelligeres Licht verwandelt. Aus einem von einem LED-Chip generierten blauen Licht, ggf. in Kombination mit einem weiteren (bspw. roten) LED-Chip kann somit weißes Licht erzeugt werden.

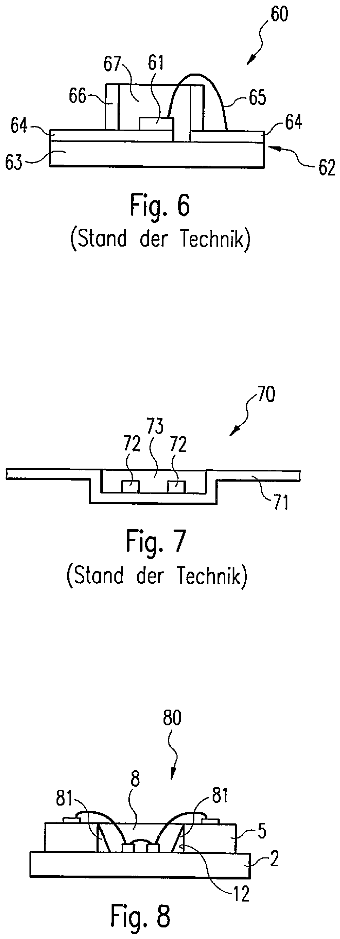

Aus dem Stand der Technik ist bereits eine in Fig. 6 gezeigte Leuchtdioden-Anordnung 60 bekannt, bei der ein Leuchtdioden-Chip 61 auf einer Basis 62 angeordnet ist, die eine Isolationsschicht 63 sowie eine elektrische leitfähige Schicht mit Leiterbahnen 64 aufweist. Der Chip 61 befindet sich auf einer Leiterbahn und ist zusätzlich mit einer weiteren Leiterbahn mittels eines Bonddrahts 65 verbunden. Um den Chip 61 ist eine Wand 66 vorgesehen. Gemäß der sogenannten "Dam and Fill" Technik wird der durch diese Wand definierte innere Bereich mit einem Farbkonversions-Mittel 67 gefüllt, wobei der Leuchtdioden-Chip 61 von diesem Material umgeben ist.

Nachteilig ist bei dieser Ausgestaltung indessen die Wärmeabfuhr ausgehend vom Leuchtdioden-Chip 61. In Lichtabstrahlrichtung und um die Wände herum befindet sich in der Tat Luft bzw. Gas. Der Chip ist auf seiner Unterseite zwar in direktem Kontakt mit einer wärmeleitfähigen Leiterbahn. Diese eignet sich aber aufgrund ihrer Größe kaum zur Übertragung von Wärme. Im unteren Bereich der Leuchtdioden-Anordnung 60 ist eine Isolationsschicht 63 vorgesehen, die eine mögliche Wärmeabfuhr verschlechtert.

Zur besseren Regulierung der Temperatur innerhalb der Leuchtdioden-Anordnung 60 ist aus dem Stand der Technik eine weitere in Fig. 7 gezeigte Anordnung 70 bekannt, bei der als Kühlkörper ein mehrere Millimeter starkes Kupferblech 71 verwendet wird, das zumindest auf der Oberseite in Lichtausstrahlrichtung hochreflektierend beschichtet ist. Im Zentrum dieses Kühlkörper-Bleches ist eine kreisförmige Vertiefung tiefgezogen, in der mehrere seriell geschaltete Leuchtdioden-Chips 72 aufgeklebt sind. Danach wurde die Vertiefung mit dem Farbkonversions-Mittel 73 z.B. Phosphor nahezu bündig vergossen.

Diese Ausgestaltung hat den Vorteil, dass der Wärmeübergang von den Leuchtdioden-Chips 72 auf den Kühlkörper nahezu optimal ist. Indessen besteht aber das Problem, dass diese Ausgestaltung Anforderungen an die Spannungsfestigkeit nicht erfüllt. Bei der bekannten Konstruktion kann es also in nachteiliger Weise zu einem unerwünschten Spannungsdurchschlag kommen. Bekannte Ausführungsformen sind im Stand der Technik, wie z.B. im US 2010/295070 A1, WO 2006/006544 A1, EP 1 487 025 A2, US 2004/211970 A1,US 2005/139846 A1, US 2011/198628 A1, offenbart.

Der vorliegenden Erfindung liegt dementsprechend die Aufgabe zugrunde, eine Möglichkeit zur Realisierung einer Leuchtdioden-Anordnung anzugeben, bei der ein guter Kompromiss zwischen Wärmeabfuhr und Spannungssicherheit sichergestellt ist. Insbesondere sollen eine gute Temperatur-Regulierung bzw. Wärmeabfuhr sowie eine hohe Spannungsfestigkeit erzielbar sein.

Die Aufgabe wird erfindungsgemäß durch die Merkmale des Anspruchs 1 gelöst. Vorteilhafte Weiterbildungen der Erfindung sind Gegenstand der Unteransprüche.

Es wird vorgeschlagen, eine seitliche Begrenzung für das Farbkonversions-Mittel, die beim Stand der Technik z.B. durch eine zusätzliche Wand oder durch den Rand des tiefgezogenen Bereichs des Blechs erzeugt ist, durch die Wand einer Ausnehmung einer vorzugsweise auf einen metallischen Kühlkörper aufgebrachten Leiterplatte (PCB) auszubilden. Die Leiterplatte kann eine oder mehrere dieser Ausnehmungen aufweisen, wobei in sämtlichen oder einigen dieser Ausnehmungen ein oder mehrere LED-Chips angeordnet sind. In diese Ausnehmung kann/können somit ein oder mehrere LED-Dies direkt auf den darunter blankliegenden metallischen Kühlkörper aufgebracht, bspw. aufgeklebt werden.

Die LED-Dies in dieser Ausnehmung werden dann vorzugsweise mittels Bonddrähten auf metallisierten Pads kontaktiert, die auf der Leiterplatte außerhalb der Ausnehmung, aber im wesentlichen angrenzend an diese, angeordnet sind. Mittels dieser Pads kann dann auch die elektrische Kontaktierung der in der Ausnehmung angeordneten LED-Dies über die üblicherweise größeren Anschlussdrähte erfolgen.

Danach wird die eine oder die mehreren Ausnehmungen in der Leiterplatte mit z.B. einer den Konversionsstoff enthaltenden Matrix vergossen, bis die Ausnehmung vorzugsweise im Wesentlichen bündig gefüllt ist.

Gemäß einem ersten Aspekt der Erfindung ist eine Leuchtdioden-Anordnung vorgeschlagen, aufweisend:
- einen vorzugsweise wärmeleitfähigen Träger,
- eine auf dem Träger angeordnete Leiterplatte, wobei in der Leiterplatte eine Ausnehmung vorgesehen ist,
- mindestens einen Leuchtdioden-Chip, der auf dem Träger und in der Ausnehmung angeordnet ist,
wobei die Ausnehmung zumindest teilweise, vorzugsweise bündig mit Matrixmaterial ausgefüllt ist, das wenigstens ein Farbkonversions-Material aufweisen kann.

Vorzugsweise kann wenigstens ein Leuchtdioden-Chip mit dem Farbkonversions-Material bedeckt sein. Die Dicke bzw. die Konzentration des Farbkonversions-Materials oberhalb des Leuchtdioden- Chips in Abstrahlrichtung wird vorzugsweise abhängig von der gewünschten Wellenlängenverschiebung ausgewählt. Je größer die Dicke bzw. Konzentration, desto stärker ist die Verschiebung des Spektrums des farbkonvertierten Lichts.

Vorzugsweise kann die Innenseite der Leiterplatte, welche die Ausnehmung in dieser Leiterplatte abgrenzt, zumindest teilweise mit dem Farbkonversions-Material bedeckt sein. Vorzugsweise können wenigstens zwei Leuchtdioden-Chips der Leuchtdioden-Anordnung unterschiedliche Emissionsspektren aufweisen.

In jeder Ausnehmung können ausschließlich Leuchtdioden-Chips angeordnet sein, die im Wesentlichen ein gleiches Emissionsspektrum aufweisen.

Vorzugsweise kann die Leiterplatte wenigstens zwei Ausnehmungen umfassen, wobei die Dicke des Farbkonversions-Materials in jeder Ausnehmung individuell angepasst werden kann. Diese Dicke kann so ausgewählt werden, dass für jede Ausnehmung individuell die Verschiebung des Spektrums des farbkonvertierten Lichts ausgewählt wird. Dadurch kann z.B. erreicht werden, dass die jeweiligen Leuchtdioden-Chips innerhalb einer Ausnehmung im Wesentlichen im selben Wellenlängenbereich Licht abstrahlen.

Ähnlich können auch in jeder Ausnehmung die Zusammensetzung und/oder die Konzentration des Farbkonversions-Materials individuell angepasst werden.

Das Mischlicht, das sich aus der Mischung des unter Leuchtstoffkonversion von jedem Leuchtdioden-Chip erzeugten Lichts ergibt, kann insbesondere ein weißes Licht sein.

Der Leuchtdioden-Chip kann mittels eines Chip-Kleber oder mittels Löten auf dem Träger befestigt sein.

Zumindest im Bereich der Ausnehmung kann der Träger in Lichtabstrahlrichtung reflektierend bzw. hochreflektierend beschichtet sein.

Auch die Innenseite der senkrechten Begrenzungswand der Ausnehmung der Leiterplatte kann reflektierend bzw. hochreflektierend beschichtet sein.

Die Innenseite der Leiterplatte, welche die Ausnehmung begrenzt, kann in Lichtabstrahlrichtung trichterförmig erweiternd ausgestaltet sein. Alternativ kann die Fläche der Ausnehmung auf der Oberseite der Leiterplatte größer als die Fläche der Ausnehmung auf der Unterseite der Leiterplatte sein.

Vorzugsweise kann innerhalb der Ausnehmung und den wenigstens einen LED-Chip seitlich umgebend ein vorzugsweise reflektierender und in Lichtabstrahlrichtung vorzugsweise trichterförmiger Reflektor angeordnet sein.

Auf der Leiterplatte und um die Ausnehmung herum kann eine über die Ebene der Leiterplatte nach oben (in Lichtabstrahlrichtung) stehende Wand derart vorgesehen sein, dass das Farbkonversions-Material in der Ausnehmung teilwiese oder vollständig bis um oberen Rand der Wand aufgefüllt werden kann. Durch diese zusätzliche "Dam-and-Fill" Technik kann die Dicke des aufgetragenen Farbkonversions-Materials oberhalb der Leuchtdioden-Chips insgesamt noch erhöht werden, und dies unabhängig von der Dicke der Leiterplatte.

Alternativ oder zusätzlich dazu kann der Träger, auf dem der wenigstens eine LED-Chip angeordnet ist, im Bereich der Ausnehmung eine Vertiefung aufweisen, in der wenigstens ein Leuchtdioden-Chip angeordnet ist. Durch diese Maßnahme kann ebenfalls die Dicke des zur Farbkonversion benutzten Farbkonversions-Materials oberhalb der Leuchtdioden-Chips in Lichtabstrahlrichtung erhöht werden.

Vorzugsweise kann auf dem Farbkonversions-Material eine Optik angeordnet sein, um beispielsweise das von den Leuchtdioden-Chips erzeugte Licht zu bündeln.

Gemäß einem weiteren Aspekt der Erfindung wird eine Leuchte vorgeschlagen, insbesondere eine Retrofit-Lampe, aufweisend eine oben definierte Leuchtdioden-Anordnung.

Gemäß einem noch weiteren Aspekt der Erfindung wird ein Verfahren zur Herstellung einer Leuchtdioden-Anordnung vorgeschlagen, aufweisend:
- das Bereitstellen eines vorzugsweise wärmeleitfähigen Trägers,
- das Anbringen von einer Leiterplatte und von mindestens einen Leuchtdioden-Chip auf den Träger, wobei in der Leiterplatte eine Ausnehmung vorgesehen ist und zumindest ein Leuchtdioden-Chip in der Ausnehmung angeordnet ist,
- das Ausfüllen der Ausnehmung zumindest teilweise mit einem Farbkonversions-Material.

Nachfolgend soll die Erfindung anhand der beiliegenden Zeichnungen näher erläutert werden. Es zeigen:
Fig. 1 eine erfindungsgemäße Ausführungsform einer Leuchtdioden-Anordnung in einer Seitenansicht,
Fig. 2 eine erfindungsgemäße Ausführungsform einer Leuchtdioden-Anordnung in einer Draufsicht,
Fig. 3 eine Darstellung einer erfindungsgemäßen Ausführungsform einer Leuchtdioden-Anordnung in Form einer Retrofit-Lampe teilweise in einem Längsschnitt,
Fig. 4 eine weitere Ausführungsform der nichterfindungsgemäßen Leuchtdioden-Anordnung,
Fig. 5 eine noch weitere Ausführungsform der nichterfindungsgemäßen Leuchtdioden-Anordnung,
Figs. 6 -7 Leuchtdioden-Anordnungen gemäß dem Stand der Technik, und
Fig. 8 eine weitere Ausführungsform der erfindungsgemäßen Leuchtdioden-Anordnung.

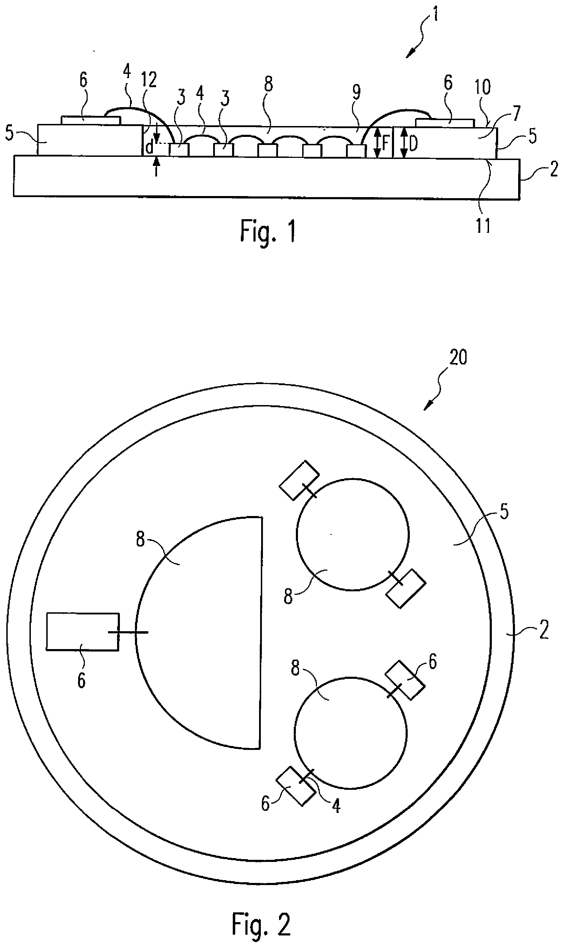

Die in Fig. 1 dargestellte und mit dem Bezugszeichen 1 versehene Leuchtdioden-Anordnung, die Teil einer Led-Lampe, insbesondere einer Retrofit LED-Lampe sein kann, weist einen Träger 2 auf, der vorzugsweise aus Metall, bspw. Aluminium, ausgebildet ist. Der Träger 2 ist als Kühlkörper ausgebildet und hat gegenüber den anderen Elementen der Anordnung eine gute thermische Leitfähigkeit und dient unter anderem der Abfuhr von Wärme, die während des Betriebs der Leuchtdioden-Anordnung 1 erzeugt wird. Die Wärmeleitfähigkeit des Trägers 2 ist insbesondere höher als die von gasförmigen Stoffen oder von Kunststoff-Werkstoffen.

Die dargestellte Leuchtdioden-Anordnung 1 umfasst mehrere Leuchtdioden-Chips 3 ("Dies"). Die Anzahl der Leuchtdioden-Chips 3 kann variieren. Die Anzahl der Leuchtdioden-Chips 3 kann z.B. so gewählt werden, dass die Leuchtdioden-Anordnung 1 insgesamt beispielsweise eine kleine Anzahl von Hochleistungs-LEDs aufweist. Eine vergleichbare Helligkeit ist alternativ mit einer insgesamt größeren Anzahl von Niedrigleistungs-LEDs erzielbar. Neben LEDs sind auch OLEDs einsetzbar. Alternative Anordnungen können auch einen einzigen Leuchtdioden-Chip 3 aufweisen. Die Anzahl der Chips, die Anzahl der LEDs pro Chip und die Leistung der einzelnen Chips sind anpassbar: diese Parameter hängen z.B. von der gewünschten Höchsthelligkeit oder Höchstleistung der Leuchtdioden-Anordnung 1 ab.

Die Leuchtdioden-Chips 3 sind auf dem Träger angeordnet und vorzugsweise gegenüber dem metallischen Träger elektrisch isoliert. Im Betrieb ist diese Anordnung insoweit vorteilhaft, dass die von den Chips erzeugte Wärme über den Träger 2 abgeführt wird. Diese Anordnung ermöglicht eine effektive Wärmeableitung von den Leuchtdioden-Chips 3. Die Chips 3 sind auf dem Träger 2 beispielsweise mit Hilfe eines thermisch relativ gut leitfähigen Klebers befestigt. Vorzugsweise wird dann ein wärmeleitfähiger Kleber eingesetzt, um die Wärmeübertragung zwischen den Chips und dem Träger 2 nicht zu beeinträchtigen bzw. zu begrenzen. Alternativ können die Chips mittels Löten auf dem Träger befestigt werden.

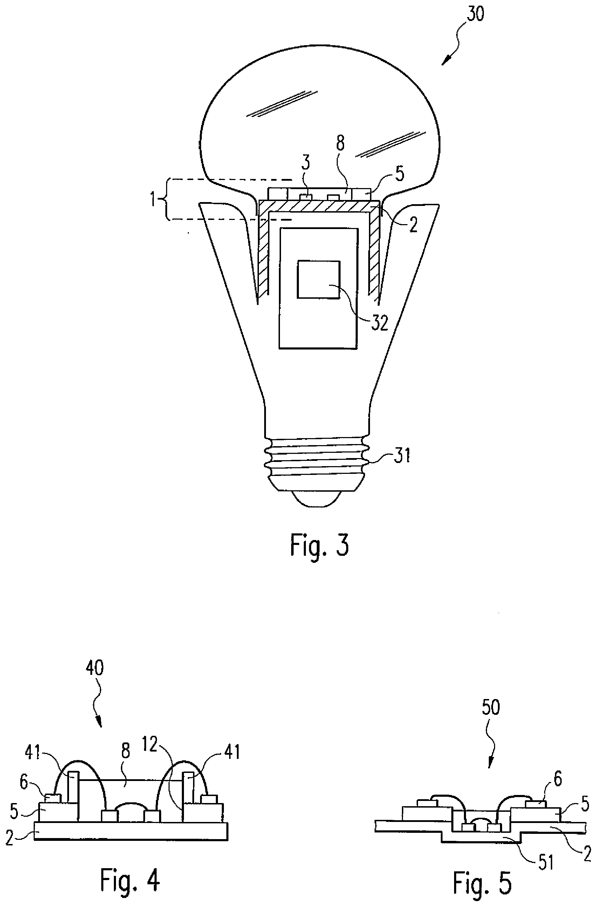

Auf dem Träger ist weiterhin eine Leiterplatte 5 oder Platine oder PCB (printed circuit board) angeordnet. Die Leiterplatte 5 besteht aus einem elektrisch isolierenden Material 7 mit darauf angebrachten leitenden Leiterbahnen und ggf. Metallisierungsflächen ("Pads") 6. Die Leiterplatte 5 und insbesondere die Leiterbahnen 6 dienen der elektrischen Verbindung der Chips 3 mit einer Betriebsschaltung, die z.B. in Fig. 3 unter dem Bezugszeichen 32 gezeigt ist und in dem Gehäuse der LED-Lampe untergebracht sein kann.

Die elektrische Kontaktierung eines Chips 3 erfolgt bspw. mittels sogenannten Bonddrähten 4, die von Pads auf der Leiterplatte zu Elektroden auf der Oberseite des Leuchtdioden-Chips 3 führen. Die elektrische Verbindung zwischen einer elektrisch leitfähigen Leiterbahn 6 und einem Chip 3 erfolgt über einen solchen Bonddraht 4. Bonddrähte sind ebenfalls zwischen den unterschiedlichen Chips 3 vorgesehen. Insgesamt sind die Leuchtdioden-Chips 3 in einer Anordnung vorzugsweise in Serie zwischen zwei Leiterbahnen 6 geschaltet. Alternativ können auch mehrere Reihenschaltungen von Leuchtdioden-Chips 3 in einer Leuchtdioden-Anordnung 1 vorgesehen sein, wobei diese Reihenschaltungen wiederum parallel zueinander zwischen den zwei Leiterbahnen 6 verschaltet sind.

Über den Leuchtdioden-Chips 3 ist wenigstens ein Farbkonversions-Material 8. Dieses Material 8 setzt zumindest einen Teil des von einem Leuchtdioden-Chip 3 abgegebenen (bspw. blauen) Lichts in Licht einer anderen Wellenlänge (bspw. grün-gelb, gelb oder orange) um. Das entstehende Mischlicht ist vorzugsweise weiss.

Hierbei wird ein Phosphor oder ein Leuchtstoff, der üblicherweise in eine Matrix eingebettet ist, innerhalb der Ausnehmung über den wenigstens einen LED-Chip dispenst. Das blaue Licht wird nunmehr in der Umgebung des Leuchtdioden-Chips 3 durch die Phosphore absorbiert und nachfolgend in langwelligeres Licht umgesetzt. Dieses längerwellige Licht der Phosphore in Kombination mit dem nicht umgesetzten blauen Licht des Leuchtdioden-Chips resultiert dann in einem weißen Mischlicht.

Weiterhin können in der durch die Ausnehmung gebildeten Vertiefung auch weitere, bspw. rote LEDs angeordnet sein, deren Licht durch das Farbkonversionsmaterial nicht in ein anderes Spektrum umgesetzt wird, deren Licht aber bspw. die Farbwiedergabe und/oder die Farbtemperatur des weißen Mischlichts modifiziert.

Die Erfindung bezieht sich indessen auch auf Ausführungsformen, bei denen ein Matrixmaterial bspw. zu Verkapselungszwecken ohne dispergiertem Konversionsmaterial über wenigstens einen LED-Chip in einer Ausnehmung in einer Leiterplatte dispenst wird. Das Matrixmaterial, bspw. Silikon, schützt somit bspw. den LED-Chip und/oder die Bonddrähte mechanisch oder gegen Feuchte. Diese Technik eignet sich auch für LED-Lampen, bei denen RGB (Rot, Grün, Blau) Chips vorgesehen sind, deren Licht durch das Matrixmaterial gestreut wird. Indessen kann auch alternativ oder zusätzlich Farbkonversionsmaterial beabstandet von den LED-Chips vorliegen, bspw. in einer Optik.

Um das von den Leuchtdioden-Chips 3 emittierte Licht farblich umzusetzen, ist nun in der Leiterplatte 5 eine Ausnehmung oder Öffnung 9 vorgesehen, welche als Durchbruch von der Oberseite 10 der Leiterplatte 5 hin zur Unterseite 11 der Leiterplatte ausgestaltet ist. Die Ausnehmung 9 ist senkrecht zur Abstrahlrichtung durch eine Innenseite 12 der Leiterplatte abgegrenzt. Diese Innenseite 12 wird durch die Ausnehmung in der Leiterplatte definiert. Die Leuchtdioden-Chips 3 sind in dieser Ausnehmung 9 angeordnet. Erfindungsgemäß können auch mehrere Ausnehmungen 9 vorgesehen sein, wobei in jeder Ausnehmung jeweils mindestens ein Chip 3 angeordnet werden kann.

Die Anordnung 1 kann eine oder mehrere LEDs und/oder OLEDs aufweisen. Dabei sind insbesondere leuchtstoffkonvertierte blaue LEDs einsetzbar, RGB-LED-Chips oder Kombinationen davon. Bei den leuchtstoffkonvertierten LEDs kann es sich insbesondere um mindestens eine blaue LED handeln, bei denen durch Farbkonvertierungsmittel wie Leuchtstoff ein Teil des ausgestrahlten blauen Lichts in gelbes, grünlich gelbes Licht umgewandelt wird. Die Anwendung von leuchtstoffkonvertierten grünen und/oder grünlich weißen LEDs ist auch denkbar. Vorzugsweise werden noch zusätzlich eine oder mehrere rote LEDs oder andere monochromatische LEDs eingesetzt, die zu einem höheren Farbwiedergabewert führen und für ein wärmeres Licht sorgen. Die roten LEDs können dabei separat zu den Leuchtstoffstoffkonvertierten blauen LEDs angeordnet sein, oder sie können sich neben diesen befinden, sodass ebenfalls ein Teil ihres ausgestrahlten roten Lichts leuchtstoffkonvertiert wird.

Wie aus der Fig. 1 ersichtlich, ist die Dicke (Tiefe) D der Leiterplatte 5 vorzugsweise größer, mehr bevorzugt mehr als das Doppelte oder Dreifache, als die Dicke d eines Chips 3:
D>d.

Entsprechend kann die Ausnehmung 9 derart von einem Farbkonversions-Material 8 ausgefüllt werden, dass die Seiten und die Oberseite der Chips 3 bedeckt sind. Vorzugsweise ist die Menge an Farbkonversions-Material 8, d.h. die Dicke F des Farbkonversions-Materials 8 in der Leuchtdioden-Anordnung 1 so gewählt, dass auch die Bonddrähte 4 zum Verbinden der Chips 3 innerhalb einer Ausnehmung vom Farbkonversions-Material 8 bedeckt sind.

Die Ausnehmung 9 ist in der Leiterplatte 5 vollständig mit dem Farbkonversions-Material 8 ausgefüllt. Daraus ergibt sich, dass z.B. der Phosphor oder Leuchtstoff bündig oder nahezu bündig vergossen wird, und dass die Höhe F des eingefüllten Farbkonversions-Materials 8 der Dicke D der Leiterplatte 5 entspricht:
F=D.

Bei einem derartigen vollständigen Ausfüllen der Ausnehmung 9 ist der Effekt der Verschiebung der Wellenlänge des erzeugten Lichts am stärksten.

Die Höhe F des Farbkonversions-Materials 8 entspricht im Wesentlichen der Dicke D der Leiterplatte 5:
(D-F)/D < 10%
oder vorzugsweise (D-F)/D < 5%
oder vorzugsweise (D-F)/D < 1%.

Die Oberfläche des Farbkonversions-Materials 8 ist vorzugsweise flach oder zumindest im Wesentlichen flach, d.h. parallel zum Träger 2 und zur Leiterplatte 5 bzw. zur Oberseite 10 der Leiterplatte. Somit kann sichergestellt werden, dass das Farbkonversions-Material 8 die Oberfläche der Leuchtdioden-Chips 3 allseitig und gleichmäßig mit einer konstanten Dicke bedeckt. Dies hat wiederum den Vorteil, dass das Licht, welches aus dem den LED-Chips umgebenen Farbkonversions-Material 8 austritt, homogen ist. An der Oberfläche der Phosphorschicht ergibt sich somit eine homogene Farbe.

Alternativ kann die Oberfläche des Farbkonversions-Materials 8 auch meniskusförmig nach oben gewölbt sein.

Die das Farbkonversions-Material 8 verlassenden Lichtstrahlen können anschließend wiederum durch eine Linse (nicht gezeigt) gebündelt werden. Diese Linse ist vorzugsweise direkt auf dem Farbkonversions-Material 8 und vorzugsweise nicht auf den Leiterbahnen 6 angebracht.

Figs. 4 und 5 zeigen weitere nichterfindungsgemäße Ausführungsformen, die es ermöglichen, beispielsweise die Verschiebung der Wellenlängen des erzeugten Lichts zu verstärken. Dies wird erreicht, indem in Bezug auf die Lichtabstrahlrichtung die Dicke des Farbkonversions-Materials 8 oberhalb der Leuchtdioden-Chips 3 vergrößert wird.

In der Anordnung 40 gemäß Fig. 4 wird die Höhe der Farbkonversions-Material-Schicht derart vergrößert, dass auf der Leiterplatte und um die Ausnehmung 9 herum eine Wand 41 angeordnet ist. Das Farbkonversions-Material 8 kann nunmehr bis zum Abschluß dieser Wand 41 ausgefüllt werden.

In der in Fig. 5 gezeigten nichterfindungsgemäßen Ausführungsform der Leuchtdioden-Anordnung 50 ist indessen im Träger 2 eine Vertiefung vorgesehen, welche z.B. durch Tiefziehen eines als Blech geformten Trägers herbeigeführt werden kann. Sind nun die Chips 3 in der Vertiefung 51 des Trägers angeordnet und die Leiterplatte 5 außerhalb dieser Vertiefung, so kann ebenfalls die Dicke des Farbkonversions-Materials 8 oberhalb der Chips vergrößert, und entsprechend die Wellenlänge des generierten Lichts weiter verschoben werden. Die nichterfindungsgemäße Ausführungsformen gemäß

Figs. 4 und 5 sind kombinierbar, um den Farbkonversions-Effekt noch zu verstärken, ohne jedoch die Wärmeleitfähigkeit der Leuchtmittel-Anordnung zu verringern.

In Fig. 2 ist eine Draufsicht einer erfindungsgemäßen Ausführungsform einer Leuchtdioden-Anordnung 20 gezeigt. Der Träger 2 ist kreisförmig ausgebildet, so dass er in einer Retrofit-Lampe einsetzbar ist. Auf dem Träger befinden sich die Leiterplatte 5 aufweisend mehrere Ausnehmungen und Leiterbahnen 6. Die Ausnehmungen sind jeweils mit Farbkonversions-Material 8 ausgefüllt. Von den Leiterbahnen 6 in Form von Pads führen Bonddrähten 4 zu den Leuchtdioden-Chips (nicht gezeigt). Von den Leiterbahnen 6 führen jeweils weitere, vorzugsweise dickere Drähte (nicht gezeigt) zu einer Stromversorgung für die LEDs.

Fig. 3 zeigt eine erfindungsgemäße Ausführungsform einer Leuchtdioden-Lampe 30 aufweisend eine erfindungsgemäße Leuchtdioden-Anordnung, insbesondere aufweisend die Leuchtdioden-Anordnung 1.

In Fig. 3 wird dargestellt eine sogenannte Retrofit Leuchtdioden-Lampe 30 zum Einsatz in einer konventionellen Lampenfassung. Hierbei weist die LED-Lampe die Form und Funktion bspw. einer konventionellen Glühbirne oder Halogenlampe auf, wobei sie jedoch als Leuchtmittel eine oder mehrere LED-Chips 3 umfasst. Hierfür weist die vorzugsweise in Form einer Birne ausgestaltete Leuchtdioden-Lampe 30 einen konventionellen Sockel 31, beispielsweise mit einem E14, E17 oder E27 Schraubgewinde auf. Alternativ ist auch ein Sockel denkbar, der für einen Niedervoltanschluss ausgelegt ist, wie ein G4, G5 oder G6 Stiftsockel. Auch denkbar ist ein BA9 oder BA15 Bajonettsockel.

Wenn die Leuchtdioden-Lampe 30 durch eine entsprechende Lampenfassung mit Netzwechselspannung oder mit Niedervoltspannung versorgt wird, wird zum korrekten Betrieb der Leuchtdioden-Anordnung 1 eine Stromanpassung benötigt. Hierfür weist die Lampe 30 eine Treiberschaltung 32 auf. Diese kann jeden für diesen Einsatz denkbaren Ansteuerschaltkreis aufweisen, wie er aus dem Stand der Technik bekannt ist. So ist beispielsweise an einen AC-DC-Wandler zur Gleichrichtung einer Netzwechselspannung zu denken. Vorteilhafterweise kann diesem ein DC-DC-Wandler oder anderer Konverter nachgeschaltet sein, der die Spannung oder den Strom oder die Leistung reduziert. Dabei kann ein Schalter eingesetzt werden, der mittels Pulsbreitenmodulation (PWM) geschaltet wird. Auch ist an eine nachgeschaltete Strombegrenzungsschaltung, beispielsweise mittels einer Transistorschaltung, zu denken.

Die Innenseite 12 der Leiterplatte ist vorzugsweise reflektierend oder hochreflektierend ausgestaltet. Dies wird durch Anbringen einer dünnen Schicht reflektierendes Material erreicht. Vorzugsweise ist diese Innenseite trichterförmig ausgestaltet, so dass das von den Leuchtdioden-Chips 3 erzeugte Licht möglichst Senkrecht zum Träger 2 reflektiert wird. Alternativ ist in Fig. 8 gezeigt, dass ein Reflektor 81 an der Innenseite 12 angeordnet ist, um das erzeugte Licht aus der Ausnehmung heraus zu reflektieren. Vorzugsweise kann der Reflektor 81 in Lichtabstrahlrichtung trichterförmig sein. Dies ist von Vorteil, weil dann die Innenseite 12 der Leiterplatte 5 senkrecht zur Leiterplattenoberfläche ausgestaltet werden kann. Dies hat wiederum den Vorteil, dass die Ausnehmung 9 einfacher, z.B. durch Bohrung, zu realisieren ist.

### Bezugszeichen

- 1: Leuchtdioden-Anordnung
- 2: Träger
- 3: Leuchtdioden-Chip (oder Leuchtdioden-Die)
- 4: Bonddraht
- 5: Leiterplatte (oder Platine oder PCB)
- 6: Leiterbahn (oder Pads)
- 7: elektrisch isolierendes Material
- 8: Farbkonversions-Material
- 9: Ausnehmung in der Leiterplatte 5
- 10: Oberseite der Leiterplatte 5
- 11: Unterseite der Leiterplatte 5
- 12: Innenseite der Leiterplatte 5
- 20: Leuchtdioden-Anordnung
- 30: Leuchtdioden -Lampe
- 31: Sockel
- 32: Treiberschaltung
- 40: Leuchtdioden-Anordnung
- 41: Wand
- 50: Leuchtdioden-Anordnung
- 51: Vertiefung
- 60: Leuchtdioden-Anordnung
- 61: Leuchtdioden-Chip
- 62: Basis
- 63: Isolationsschicht
- 64: Leiterbahn
- 65: Bonddraht
- 66: Wand
- 67: Farbkonversions-Mittel
- 70: Leuchtdioden-Anordnung
- 71: Kupferblech
- 72: Leuchtdioden-Chip
- 73: Farbkonversions-Mittel
- 80: Leuchtdioden-Anordnung
- 81: Reflektor

## Patentansprüche

1. Leuchtdioden-Anordnung, aufweisend:
- einen vorzugsweise metallischen, wärmeleitfähigen Träger (2),
- eine auf dem Träger (2) angeordnete Leiterplatte (5), wobei in der Leiterplatte (5) eine Ausnehmung (9) vorgesehen ist,
- mindestens einen Leuchtdioden-Chip (3), der auf dem Träger (2) und in der Ausnehmung (9) angeordnet ist sowie elektrisch mit der Leiterplatte kontaktiert ist,
wobei die Ausnehmung (9) mit wenigstens einem ein Farbkonversions-Material (8) aufweisenden Matrixmaterial ausgefüllt ist
wobei
die Höhe des Farbkonversions-Materials (8) im Wesentlichen der Dicke (D) der Leiterplatte (5) entspricht.

2. Leuchtdioden-Anordnung nach einem der vorigen Ansprüche,
wobei die Innenseite (12) der Leiterplatte (5), welche die Ausnehmung (9) in dieser Leiterplatte (5) abgrenzt, zumindest teilweise mit dem Farbkonversions-Material (8) bedeckt ist.

3. Leuchtdioden-Anordnung nach einem der vorigen Ansprüche,
wobei die Leuchtdioden-Anordnung wenigstens zwei Leuchtdioden-Chips (3) umfasst, welche unterschiedliche Emissionsspektren aufweisen, wobei die genannten zwei LED-Chips in der gleichen oder in unterschiedlichen Ausnehmungen in der Leiterplatte angeordnet sind.

4. Leuchtdioden-Anordnung nach einem der vorigen Ansprüche,
wobei in jeder Ausnehmung (9) ausschließlich Leuchtdioden-Chips (3) angeordnet sind, die im Wesentlichen ein gleiches Emissionsspektrum aufweisen.

5. Leuchtdioden-Anordnung nach einem der vorigen Ansprüche,
wobei die Leiterplatte (5) wenigstens zwei Ausnehmungen (9) umfasst, wobei die Dicke des Farbkonversions-Materials (8) im Wesentlichen der Dicke (D) der Leiterplatte (5) entspricht.

6. Leuchtdioden-Anordnung nach einem der vorigen Ansprüche,
wobei in jeder Ausnehmung die Zusammensetzung und/oder die Konzentration des Farbkonversions-Materials (8) individuell angepasst ist.

7. Leuchtdioden-Anordnung nach einem der vorigen Ansprüche,
wobei das Mischlicht, das sich aus der Mischung des unter Leuchtstoffkonversion von jedem Leuchtdioden-Chip (3) erzeugten Lichts ergibt, ein weißes Licht ist.

8. Leuchtdioden-Anordnung nach einem der vorigen Ansprüche,
bei der der Leuchtdioden-Chip (3) mittels eines Chip-Kleber oder Löten auf dem Träger (2) befestigt ist.

9. Leuchtdioden-Anordnung nach einem der vorigen Ansprüche,
wobei zumindest im Bereich der Ausnehmung (9) der Träger (2) in Lichtabstrahlrichtung reflektierend bzw. hochreflektierend beschichtet ist.

10. Leuchtdioden-Anordnung nach einem der vorigen Ansprüche,
wobei die Innenseite (12) der Leiterplatte (5), welche die Ausnehmung (9) abgrenzt, reflektierend bzw. hochreflektierend beschichtet ist.

11. Leuchtdioden-Anordnung nach einem der vorigen Ansprüche,
wobei die Innenseite (12) der Leiterplatte (5), welche die Ausnehmung (9) abgrenzt, in Lichtabstrahlrichtung gesehen trichterförmig ausgestaltet ist, oder wobei die Fläche der Ausnehmung (9) auf der Oberseite (10) der Leiterplatte (5) größer als die Fläche der Ausnehmung (9) auf der Unterseite (10) der Leiterplatte (5).

12. Leuchtdioden-Anordnung nach einem der vorigen Ansprüche,
wobei auf der Innenseite (12) der Leiterplatte (5), welche die Ausnehmung (9) definiert, ein vorzugsweise reflektierender und in Lichtabstrahlrichtung vorzugsweise trichterförmiger Reflektor (81) angeordnet ist.

13. Leuchtdioden-Anordnung nach einem der vorigen Ansprüche,
wobei auf dem Farbkonversions-Material (8) eine Linse angeordnet ist.

14. LED-Lampe, insbesondere Retrofit LED-Lampe (30), aufweisend eine Leuchtdioden-Anordnung nach einem der vorigen Ansprüche.

15. Verfahren zur Herstellung einer Leuchtdioden-Anordnung, aufweisend:
- das Bereitstellen eines vorzugsweise wärmeleitfähigen Trägers (2),
- das Anbringen von einer Leiterplatte (5) und von mindestens einen Leuchtdioden-Chip (3) auf den Träger (2), wobei in der Leiterplatte (5) eine Ausnehmung (9) vorgesehen ist und der Leuchtdioden-Chip (3) in der Ausnehmung (9) angeordnet ist,
- das Ausfüllen der Ausnehmung (9) mit einem Matrixmaterial, das wenigstens ein Farbkonversions-Material (8) aufweist
**dadurch gekennzeichnet,**
**dass** die Höhe des Farbkonversions-Materials (8) im Wesentlichen der Dicke (D) der Leiterplatte (5) entspricht.

## Claims

1. Light-emitting diode arrangement comprising:
- a preferably metallic, thermally conductive carrier (2),
- a circuit board (5) arranged on the carrier (2), wherein a recess (9) is provided in the circuit board (5),
- at least one light-emitting diode chip (3), which is arranged on the carrier (2) and in the recess (9) and is in electrical contact with the circuit board,
wherein the recess (9) is filled with at least one matrix material comprising a luminescence conversion material (8), wherein the height of the luminescence conversion material (8) substantially corresponds to the thickness (D) of the circuit board (5).

2. Light-emitting diode arrangement according to one of the preceding claims,
wherein the inner side (12) of the circuit board (5) which delimits the recess (9) in this circuit board (5) is at least partially covered with the luminescence conversion material (8).

3. Light-emitting diode arrangement according to one of the preceding claims,
wherein the light-emitting diode arrangement comprises at least two light-emitting diode chips (3) which have different emission spectra, wherein said two LED chips are arranged in the same or in different recesses in the circuit board.

4. Light-emitting diode arrangement according to one of the preceding claims,
wherein in each recess (9) are arranged only light-emitting diode chips (3) which have substantially the same emission spectrum.

5. Light-emitting diode arrangement according to one of the preceding claims,
wherein the circuit board (5) comprises at least two recesses (9), wherein the thickness of the luminescence conversion material (8) substantially corresponds to the thickness (D) of the circuit board (5) .

6. Light-emitting diode arrangement according to one of the preceding claims,
wherein the composition and/or the concentration of the luminescence conversion material (8) is individually adjusted in each recess.

7. Light-emitting diode arrangement according to one of the preceding claims,
wherein the mixed light resulting from the mixture of the light generated by each light-emitting diode chip (3) under luminescence conversion is a white light.

8. Light-emitting diode arrangement according to one of the preceding claims,
in which the light-emitting diode chip (3) is fastened to the carrier (2) by means of a chip adhesive or soldering.

9. Light-emitting diode arrangement according to one of the preceding claims,
wherein, at least in the region of the recess (9), the carrier (2) is coated in a reflective or highly reflective manner in the light-radiating direction.

10. Light-emitting diode arrangement according to one of the preceding claims,
wherein the inner side (12) of the circuit board (5) which delimits the recess (9) is coated in a reflective or highly reflective manner.

11. Light-emitting diode arrangement according to one of the preceding claims,
wherein the inner side (12) of the circuit board (5) which delimits the recess (9) is designed to be funnel-shaped when viewed in the light-radiating direction, or wherein the surface of the recess (9) on the upper side (10) of the circuit board (5) is greater than the surface of the recess (9) on the lower side (10) of the circuit board (5).

12. Light-emitting diode arrangement according to one of the preceding claims,
wherein a preferably reflective reflector (81) which is preferably funnel-shaped in the light-radiating direction is arranged on the inner side (12) of the circuit board (5) which defines the recess (9) .

13. Light-emitting diode arrangement according to one of the preceding claims,
wherein a lens is arranged on the luminescence conversion material (8) .

14. LED lamp, in particular retrofit LED lamp (30), comprising a light-emitting diode arrangement according to one of the preceding claims.

15. Method for producing a light-emitting diode arrangement, comprising:
- providing a preferably thermally conductive carrier (2),
- mounting a circuit board (5) and at least one light-emitting diode chip (3) on the carrier (2), wherein a recess (9) is provided in the circuit board (5) and the light-emitting diode chip (3) is arranged in the recess (9),
- filling the recess (9) with a matrix material comprising at least one luminescence conversion material (8),
**characterized in that**
the height of the luminescence conversion material (8) substantially corresponds to the thickness (D) of the circuit board (5) .

## Revendications

1. Système à diodes électroluminescentes, présentant :
- un support de préférence métallique et susceptible de conduire la chaleur (2),
- un circuit imprimé (5) disposé sur le support (2), un évidement (9) étant prévu dans le circuit imprimé (5),
- au moins une puce à diodes électroluminescentes (3) disposée sur le support (2) et dans l'évidement (9) et qui est en contact électrique avec le circuit imprimé ;
dans lequel l'évidement (9) est rempli avec au moins un matériau matriciel présentant un matériau de conversion de couleur (8), la hauteur du matériau de conversion de couleur (8) correspondant essentiellement à l'épaisseur (D) du circuit imprimé (5).

2. Système à diodes électroluminescentes selon l'une des revendications précédentes,
dans lequel la face intérieure (12) du circuit imprimé (5) qui délimite l'évidement (9) réalisé dans ce circuit imprimé (5) est recouverte au moins partiellement par le matériau de conversion de couleur (8).

3. Système à diodes électroluminescentes selon l'une des revendications précédentes,
dans lequel le système à diodes électroluminescentes comprend au moins deux puces à diodes électroluminescentes (3) présentant des spectres d'émission différents, lesdites deux puces à DEL étant disposées dans un même évidement ou dans des évidements différents réalisés dans le circuit imprimé.

4. Système à diodes électroluminescentes selon l'une des revendications précédentes,
dans lequel seules des puces à diodes électroluminescentes (3) présentant essentiellement un spectre d'émission identique sont disposées dans chaque évidement (9).

5. Système à diodes électroluminescentes selon l'une des revendications précédentes,
dans lequel le circuit imprimé (5) comprend au moins deux évidements (9), l'épaisseur du matériau de conversion de couleur (8) correspondant essentiellement à l'épaisseur (D) du circuit imprimé (5).

6. Système à diodes électroluminescentes selon l'une des revendications précédentes,
dans lequel, dans chaque évidement, la composition et/ou la concentration du matériau de conversion de couleur (8) sont adaptées individuellement.

7. Système à diodes électroluminescentes selon l'une des revendications précédentes,
dans lequel la lumière mixte, résultant du mélange de la lumière émise par chaque puce à diodes électroluminescentes (3) subissant une conversion de luminophore, est une lumière blanche.

8. Système à diodes électroluminescentes selon l'une des revendications précédentes,
dans lequel la puce à diodes électroluminescentes (3) est fixée sur le support (2) à l'aide d'un adhésif à puce ou par brasage.

9. Système à diodes électroluminescentes selon l'une des revendications précédentes,
dans lequel, au moins dans la zone de l'évidement (9), le support (2) est doté d'un revêtement réfléchissant ou hautement réfléchissant dans la direction de diffusion de lumière.

10. Système à diodes électroluminescentes selon l'une des revendications précédentes,
dans lequel la face intérieure (12) du circuit imprimé (5) qui délimite l'évidement (9) est dotée d'un revêtement réfléchissant ou hautement réfléchissant.

11. Système à diodes électroluminescentes selon l'une des revendications précédentes,
dans lequel la face intérieure (12) du circuit imprimé (5) qui délimite l'évidement (9) est conçue en forme d'entonnoir dans la direction de diffusion de lumière, ou dans lequel la surface de l'évidement (9) sur la face supérieure (10) du circuit imprimé (5) est supérieure à la surface de l'évidement (9) sur la face inférieure (10) du circuit imprimé (5).

12. Système à diodes électroluminescentes selon l'une des revendications précédentes,
dans lequel un réflecteur (81), de préférence en forme d'entonnoir dans la direction de diffusion de lumière et de préférence réfléchissant, est disposé sur la face intérieure (12) du circuit imprimé (5) qui définit l'évidement (9).

13. Système à diodes électroluminescentes selon l'une des revendications précédentes,
dans lequel une lentille est disposée sur le matériau de conversion de couleur (8).

14. Lampe à DEL, en particulier lampe à DEL (30) de rattrapage, présentant un système à diodes électroluminescentes selon l'une des revendications précédentes.

15. Procédé de fabrication d'un système à diodes électroluminescentes comprenant :
- la mise à disposition d'un support (2) de préférence susceptible de conduire la chaleur,
- la fixation d'un circuit imprimé (5) et d'au moins une puce à diodes électroluminescentes (3) sur le support (2), un évidement (9) étant prévu dans le circuit imprimé (5) et la puce à diodes électroluminescentes (3) étant disposée dans l'évidement (9),
- le remplissage de l'évidement (9) avec un matériau matriciel présentant au moins un matériau de conversion de couleur (8) ;
**caractérisé en ce que**
la hauteur du matériau de conversion de couleur (8) correspond essentiellement à l'épaisseur (D) du circuit imprimé (5).
